# EUROPÄISCHE PATENTANMELDUNG

(11) **EP 3 088 724 A1**
(43) Veröffentlichungstag der Anmeldung: **02.11.2016**
(21) Anmeldenummer: 16165805.9
(22) Anmeldetag: 18.04.2016
(51) Int. Cl.: F02M 57/00, H01L 41/113, H01L 41/25, H01L 41/23

(54) **KRAFTSTOFFINJEKTOR**

(30) Priorität: 30.04.2015 DE 102015208069
(71) Anmelder: ROBERT BOSCH GMBH, 70442 Stuttgart (DE)
(72) Erfinder: Cromme, Peter, 96050 Bamberg (DE); Forke, Martin, 70499 Stuttgart (DE); Malt, Falko, 96120 Bischberg (DE)

(57) **Zusammenfassung**

Die Erfindung betrifft einen Kraftstoffinjektor (10), insbesondere Common-Rail-Injektor, mit einem Injektorgehäuse (11), in dem ein Hochdruckraum (15) ausgebildet ist, der über eine im Injektorgehäuse (11) angeordnete Versorgungsbohrung (19) mit unter Druck stehendem Kraftstoff versorgbar ist, mit wenigstens einer zumindest mittelbar mit dem Hochdruckraum (15) verbundenen, im Injektorgehäuse (11) ausgebildeten Einspritzöffnung (12) zum Einspritzen von Kraftstoff in den Brennraum einer Brennkraftmaschine, mit einem die wenigstens eine Einspritzöffnung (12) freigebenden oder verschließenden Einspritzglied (16), und mit einer Messeinrichtung (30) zur zumindest mittelbaren Erfassung des Drucks im Hochdruckraum (15) oder der Versorgungsbohrung (19), wobei die Messeinrichtung (30) dazu ausgebildet ist, eine elastische Verformung eines zumindest mittelbar mit der Versorgungsbohrung (19) oder dem Hochdruckraum (15) in Wirkverbindung angeordneten Verformungsbereichs (27) zu erfassen, wobei die Messeinrichtung (30) ein Sensorelement (32) aufweist, das in Wirkverbindung mit der Oberfläche des Verformungsbereichs (27) verbunden ist, und wobei das Sensorelement (32) mittels einer das Sensorelement (32) zumindest teilweise überdeckenden Einrichtung in Richtung des Verformungsbereichs (27) mit einer Vorspannkraft (F) kraftbeaufschlagt ist.

## Beschreibung

### Stand der Technik

Die Erfindung betrifft einen Kraftstoffinjektor nach dem Oberbegriff des Anspruchs 1.

Ein derartiger Kraftstoffinjektor ist aus der nachveröffentlichten DE 10 2014 222 811 A1 der Anmelderin bekannt. Bei dem bekannten Kraftstoffinjektor wird eine ein Piezoelement aufweisende Messeinrichtung unter Zwischenlage einer Klebstoffschicht an der Oberfläche eines Verformungsbereichs eines Injektorgehäuses des Kraftstoffinjektors befestigt. Mittels der Messeinrichtung lässt sich zumindest mittelbar der Druck in einer Versorgungsbohrung bzw. einem Hochdruckraum des Kraftstoffinjektors ermitteln, woraus auf einen Schließ- bzw. Öffnungszeitpunkt eines Ventilglieds (Düsennadel) geschlossen werden kann. Die Messeinrichtung ist im Bereich einer Vertiefung des Injektorgehäuses angeordnet und mittels einer das Sensorelement an seiner der Klebstoffschicht gegenüberliegenden Stirnseite überdeckenden Einrichtung überdeckt. Die Einrichtung dient dazu, auf das Piezoelement eine (axiale) Vorspannkraft auszuüben, welche zum einen die Zuverlässigkeit der Messeinrichtung über die Lebensdauer des Kraftstoffinjektors gesehen erhöht, und zum anderen die Funktionalität des Piezoelements insofern verbessert, als dass auf das Piezoelement infolge der Deformation eines Verformungsbereichs wirkende Zugspannungen reduziert werden. Hierzu ist die das Piezoelement teilweise überdeckende Einrichtung im Bereich der Vertiefung mit einer Schweißnaht mit dem Injektorgehäuse verbunden, um die benötigte Vorspannkraft auf das Piezoelement zu erzeugen. Um einen Medienzutritt zu dem Piezoelement zu vermeiden, welcher die Funktionseigenschaften des Piezoelements, insbesondere über die Lebensdauer des Kraftstoffinjektors betrachtet, verschlechtern kann, ist es erforderlich, dass zwischen der Aufnahme bzw. Vertiefung in dem Injektorgehäuse und der das Sensorelement teilweise überdeckenden Einrichtung eine vollständig umlaufende Schweißnaht ausgebildet wird, die den Bereich des Piezoelements abdichtet.

### Offenbarung der Erfindung

Ein Kraftstoffinjektor mit den Merkmalen des Anspruchs 1 bietet den besonderen Vorteil, dass unabhängig von der Geometrie des Injektorgehäuses im Bereich des Anbauorts der Messeinrichtung ein Schutz des Piezoelements der Messeinrichtung gegenüber Medieneinflüssen erzielbar ist. Weiterhin bietet der Kraftstoffinjektor mit den Merkmalen des Anspruchs 1 den Vorteil, dass auf die Verwendung von Klebstoff bzw. einer Klebstoffschicht verzichtet werden kann, wodurch sich der Herstellungsprozess des Kraftstoffinjektors bzw. die Montage der Messeinrichtung vereinfacht. Diese Vorteile werden erfindungsgemäß dadurch erzielt, dass das Sensorelement unmittelbar an dem Verformungsbereich aufliegt, und dass die Einrichtung zur Kraftbeaufschlagung des Sensorelements ein das Sensorelement mit Ausnahme der an dem Verformungsbereich anliegenden Stirnseite des Sensorelements umschließendes, zumindest bereichsweise flexibel ausgebildetes Sensorgehäuse ist.

Vorteilhafte Weiterbildungen des erfindungsgemäßen Kraftstoffinjektors sind in den Unteransprüchen aufgeführt.

Um einerseits einen möglichst guten Schutz des Sensorelements zu gewährleisten, und andererseits in besonders einfacher Art und Weise die erforderliche Vorspannkraft auf das Sensorelement erzeugen zu können, ohne auf eine bestimmte Geometrie einer sacklochförmigen Vertiefung angewiesen zu sein, ist es vorgesehen, dass das Sensorgehäuse topf- bzw. deckeiförmig ausgebildet ist und eine Aufnahme für das Sensorelement aufweist, deren Tiefe geringer ist als die Höhe des Sensorelements. Eine derartige geometrische Gestaltung des Sensorgehäuses ermöglicht es, mit Ausnahme der an dem Verformungsbereich anliegenden Stirnseite des Sensorelements, das Sensorelement vollständig zu umschließen und damit einen optimalen Schutz gegen Medieneinflüsse zu gewährleisten und aufgrund der geometrischen Ausbildung bzw. Tiefe der Aufnahme für das Sensorelement die benötigte Vorspannkraft auf das Sensorelement zu erzeugen, wenn das Sensorgehäuse beispielsweise mit dem Grund der Vertiefung im Verformungsbereich verbunden ist.

In konstruktiver Weiterbildung zur Erzeugung der Vorspannkraft ist es bei dem zuletzt genannten Vorschlag vorgesehen, dass das Sensorgehäuse einen das Sensorelement an dessen Umfang umgebenden Wandabschnitt aufweist, und dass der Wandabschnitt in Richtung der Kraftbeaufschlagung des Sensorelements elastisch ausgebildet ist. In der Praxis kann ein derartiger Wandausschnitt beispielsweise dadurch ausgebildet sein, dass das Sensorgehäuse als Tiefziehteil aus Blech besteht und der Wandabschnitt eine relativ geringe Wanddicke aufweist.

Um auf besonders einfache Art und Weise eine Verbindung des Sensorgehäuses mit dem Injektorgehäuse zu ermöglichen, ist es vorgesehen, dass das Sensorgehäuse aus Metall besteht und mit dem Injektorgehäuse mittels einer Schweißverbindung, insbesondere mittels einer Laserschweißnaht, verbunden ist.

Die Verbindung des Sensorgehäuses im Verbindungsbereich zum Verformungsbereich erfolgt vorzugsweise über einen radial umlaufenden Befestigungsflansch, der am Sensorgehäuse einstückig angeformt ist. Dies hat den Vorteil, dass keine zusätzlichen, separaten Bauteile zur Befestigung der Messeinrichtung erforderlich sind.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: eine stark vereinfachte, teilweise geschnittene Seitenansicht eines erfindungsgemäßen Kraftstoffinjektors mit einer Messeinrichtung zur zumindest mittelbaren Erfassung des Kraftstoffdrucks im Kraftstoffinjektor und
- Fig. 2: ein Detail der Fig. 1 im Verbindungsbereich zwischen dem Kraftstoffinjektor und der Messeinrichtung in vergrößerter Darstellung im Längsschnitt.

Gleiche Elemente bzw. Elemente mit gleicher Funktion sind in den Figuren mit den gleichen Bezugsziffern versehen.

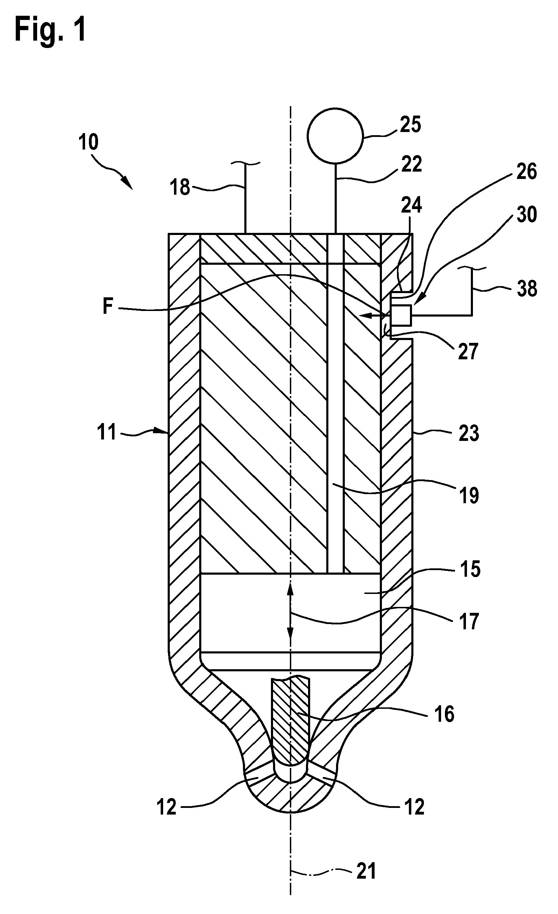

Der in der Fig. 1 stark vereinfacht dargestellte Kraftstoffinjektor 10 ist als sogenannter Common-Rail-Injektor ausgebildet, und dient dem Einspritzen von Kraftstoff in den nicht gezeigten Brennraum einer Brennkraftmaschine, insbesondere einer selbstzündenden Brennkraftmaschine.

Der Kraftstoffinjektor 10 weist ein im Wesentlichen aus Metall bestehendes, ggf. mehrteilig ausgebildetes Injektorgehäuse 11 auf, in dem auf der dem Brennraum der Brennkraftmaschine zugewandten Seite wenigstens eine, vorzugsweise mehrere Einspritzöffnungen 12 zum Einspritzen des Kraftstoffs eingeordnet sind. Innerhalb des Injektorgehäuses 11 bildet dieses einen Hochdruckraum 15 aus, in dem eine als Einspritzglied dienende Düsennadel 16 in Richtung des Doppelpfeils 17 hubbeweglich angeordnet ist. In der dargestellten, abgesenkten Stellung der Düsennadel 16 bildet diese zusammen mit der Innenwand des Hochdruckraums 15 bzw. des Injektorgehäuses 11 einen Dichtsitz aus, so dass die Einspritzöffnungen 12 zumindest mittelbar verschlossen sind, derart, dass das Einspritzen von Kraftstoff aus dem Hochdruckraum 15 in den Brennraum der Brennkraftmaschine vermieden wird. In der anderen, nicht dargestellten, von dem Dichtsitz abgehobenen Position der Düsennadel 16 gibt diese die Einspritzöffnungen 12 zum Einspritzen des Kraftstoffs in den Brennraum der Brennkraftmaschine frei. Die Bewegung der Düsennadel 16, insbesondere zum Freigeben der Einspritzöffnungen 12, erfolgt auf eine an sich bekannte Art und Weise mittels eines nicht dargestellten Aktuators, der über eine Spannungsversorgungsleitung 18 von einer Steuereinrichtung der Brennkraftmaschine ansteuerbar ist. Bei dem Aktuator kann es sich insbesondere um einen Magnetaktuator oder aber um einen Piezoaktuator handeln.

Die Versorgung des Hochdruckraums 15 mit unter Hochdruck (Systemdruck) stehendem Kraftstoff erfolgt über eine innerhalb des Injektorgehäuses 11 angeordnete bzw. in Bauteilen des Kraftstoffinjektors 10 ausgebildete Versorgungsbohrung 19, die insbesondere exzentrisch zur Längsachse 21 des Injektorgehäuses 11 in einem Randbereich des Kraftstoffinjektors 10, zumindest im Wesentlichen parallel zur Längsachse 21, verläuft. Die Versorgungsbohrung 19 ist darüber hinaus über einen nicht dargestellten Kraftstoffanschlussstutzen mit einer Kraftstoffleitung 22 verbunden, welche wiederum mit einem Kraftstoffspeicher 25 (Rail) gekoppelt ist.

In einem von den Einspritzöffnungen 12 axial relativ weit beabstandeten Bereich des Injektorgehäuses 11 ist in dessen Außenwand 23 beispielhaft eine sacklochförmige Vertiefung 24 ausgebildet, so dass die Wanddicke des Injektorgehäuses 11 im Bereich der Vertiefung 24 reduziert ist. Ergänzend wird erwähnt, dass anstelle einer sacklochförmigen Vertiefung 24 das Injektorgehäuse 11 auch eine Abflachung aufweisen kann, in deren Bereich die Wanddicke des Injektorgehäuses 11 reduziert ist.

Der eben ausgebildete Grund 26 der Vertiefung 24 bildet einen Teil eines Verformungsbereichs 27 aus. Dadurch wirkt der in der Versorgungsbohrung 19 augenblicklich herrschende Kraftstoffdruck in dem Injektorgehäuse 11 auch auf der der Vertiefung 24 abgewandten Seite. Dadurch, dass die Wanddicke des Injektorgehäuses 11 im Bereich der Vertiefung 24 reduziert ist, wirkt die Wand des Injektorgehäuses 11 auf der der Vertiefung 24 zugewandten Seite des Verformungsbereichs 27 in Art einer elastisch verformbaren Membran, wobei die Verformung, welche sich als konvexe Wölbung ausbildet, umso größer ist, je höher der augenblickliche Kraftstoffdruck in der Versorgungsbohrung 19 ist.

Zur Detektion des augenblicklichen Kraftstoffdrucks in der Versorgungsbohrung 19 und damit auch in dem Hochdruckraum 15, welcher als Indiz für die augenblickliche Stellung der Düsennadel 16 zur Ansteuerung der Düsennadel 16 verwendet wird, weist der Kraftstoffinjektor 10 eine Messeinrichtung 30 auf. Die Messeinrichtung 30 umfasst ein als Piezoelement 31 ausgebildetes Sensorelement 32.

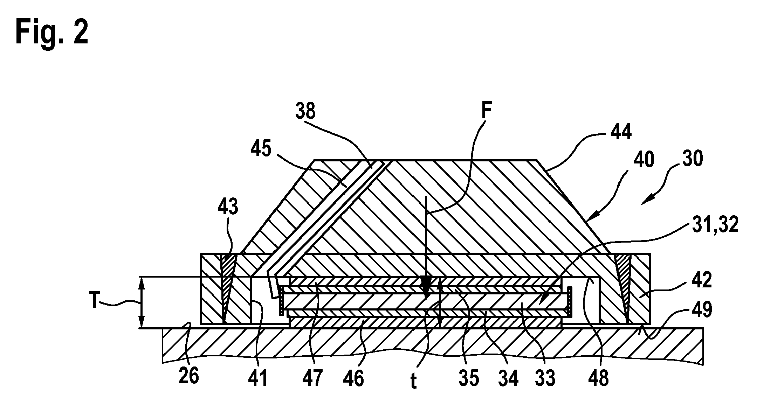

Wie insbesondere anhand der Fig. 2 erkennbar ist, weist das Piezoelement 31 zwei, durch eine Piezokeramik 33 voneinander getrennte (metallisierte) Elektrodenschichten 34, 35 auf, die über elektrische Anschlussleitungen 38 elektrisch kontaktiert sind, wobei die Anschlussleitungen 38 beispielsweise mit einer elektrischen Steuereinheit bzw. einem elektronischen Steuergerät des Kraftfahrzeugs verbunden sind. Über das Piezoelement 31 wird in bekannter Art und Weise eine Deformation des Verformungsbereichs 27 erfasst, wobei das von dem Piezoelement 31 erzeugte Spannungssignal umso größer ist, je größer die Deformation des Verformungsbereichs 27 ist.

Das Piezoelement 31 bzw. das Sensorelement 32 ist in einem Sensorgehäuse 40 aufgenommen. Das Sensorgehäuse 40 besteht vorzugsweise aus Blech bzw. Metall und ist im Tiefziehverfahren hergestellt. Darüber hinaus ist das Sensorgehäuse 40 zumindest im Wesentlichen topf- bzw. deckeiförmig ausgebildet und weist beispielhaft eine zylindrisch ausgebildete Aufnahme 41 zur Aufnahme des Sensorelements 32 auf. Das Sensorgehäuse 40 weist darüber hinaus einen radial umlaufenden Befestigungsbereich 42 in Form eines Befestigungsflanschs auf, über den das Sensorgehäuse 40 vorzugsweise mittels einer Schweißnaht 43, welche ebenfalls radial umlaufend ausgebildet ist, mit dem Grund 26 der Vertiefung 24 verbunden ist. Insbesondere ist es vorgesehen, dass die Schweißnaht 43 als Laserschweißnaht ausgebildet ist bzw. durch eine Laserstrahleinrichtung erzeugt wurde.

Auf der dem Grund 26 der Vertiefung 24 abgewandten Seite weist das Sensorgehäuse 40 einen kegelstumpfförmig ausgebildeten Abschlussbereich 44 auf, in dem wenigstens eine als Durchgangsöffnung ausgebildete Durchführung 45 ausgebildet ist, in der die Anschlussleitungen 38 angeordnet sind. Die Anschlussleitungen 38 sind im Bereich der Durchführung 45 vorzugsweise von einer Isolationsmasse in Form einer Klebstoffmasse oder ähnlichem umgeben, um die Anschlussleitungen 38 gegenüber der Umgebung abzudichten bzw. einen Medienzutritt in den Bereich der Aufnahme 41 des Sensorgehäuses 40 zu vermeiden (nicht dargestellt).

Innerhalb der durch die Schweißnaht 43 gegenüber der Umgebung mediendicht angeordneten Aufnahme 41 ist das Sensorelement 32 bzw. das Piezoelement 31 unter Zwischenlage zweier Isolationsschichten 46, 47 in der Aufnahme 41 aufgenommen. Während die eine, aus elektrisch nicht leitendem Material bestehende Isolationsschicht 46 unmittelbar am Grund 26 der Vertiefung 24 aufliegt und auf der dem Grund 26 abgewandten Seite von der einen Elektrodenschicht 34 überdeckt ist, befindet sich die andere Isolationsschicht 47 zwischen dem Grund 48 der Aufnahme 41 und der anderen Elektrodenschicht 35.

Wesentlich ist, dass die Höhe t des Sensorelements 32, bestehend aus dem Piezoelement 31 und den beiden Isolationsschichten 46, 47, in nicht montiertem Zustand des Sensorgehäuses 40 etwas größer ist als die Tiefe T der Aufnahme 41, gemessen von der dem Grund 26 der Vertiefung 24 zugewandten Stirnfläche 49 der Aufnahme 41 und dem Grund 48 der Aufnahme 41. Darüber hinaus ist das Sensorgehäuse 40 zumindest bereichsweise elastisch ausgebildet, vorzugsweise im Bereich des das Sensorelement 32 radial umgebenden Wandabschnitts 51 des Sensorgehäuses 40. Dadurch wird bei der Montage des Sensorgehäuses 40 mit in der Aufnahme 41 angeordnetem Sensorelement 32 eine axiale Vorspannkraft F auf das Piezoelement 31 erzeugt.

Ergänzend wird erwähnt, dass in der Darstellung der Fig. 2 zwischen der Stirnfläche 49 des Sensorgehäuses 40 und dem Grund 26 ein kleiner Spalt bzw. Abstand dargestellt ist. Dies dient jedoch nur dazu, den Unterschied zwischen der Tiefe T der Aufnahme 41 und der Höhe t des Sensorelements 32 zu erkennen. Durch die Schweißnaht 43 wird jedoch ein Anlagekontakt zwischen der Stirnfläche 49 des Sensorgehäuses 40 und dem Grund 26 erzeugt.

Beim Betrieb des Kraftstoffinjektors 10 verformt sich der Verformungsbereich 27 des Injektorgehäuses 11 in Abhängigkeit des in der Versorgungsbohrung 19 herrschenden Kraftstoffdrucks elastisch nach außen. Diese Verformung überträgt sich über die eine Isolationsschicht 46 auf das Piezoelement 31 und erzeugt dort in Abhängigkeit der Verformung elektrische Spannungen, die mittels einer geeigneten Auswerteschaltung dazu verwendet werden können, zumindest mittelbar auf eine Stellung der Düsennadel 16 in dem Injektorgehäuse 11 zu schließen.

Der soweit beschriebene Kraftstoffinjektor 10 kann in vielfältiger Art und Weise abgewandelt bzw. modifiziert werden, ohne vom Erfindungsgedanken abzuweichen.

## Patentansprüche

1. Kraftstoffinjektor (10), insbesondere Common-Rail-Injektor, mit einem Injektorgehäuse (11), in dem ein Hochdruckraum (15) ausgebildet ist, der über eine im Injektorgehäuse (11) angeordnete Versorgungsbohrung (19) mit unter Druck stehendem Kraftstoff versorgbar ist, mit wenigstens einer zumindest mittelbar mit dem Hochdruckraum (15) verbundenen, im Injektorgehäuse (11) ausgebildeten Einspritzöffnung (12) zum Einspritzen von Kraftstoff in den Brennraum einer Brennkraftmaschine, mit einem die wenigstens eine Einspritzöffnung (12) freigebenden oder verschließenden Einspritzglied (16), und mit einer Messeinrichtung (30) zur zumindest mittelbaren Erfassung des Drucks im Hochdruckraum (15) oder der Versorgungsbohrung (19), wobei die Messeinrichtung (30) dazu ausgebildet ist, eine elastische Verformung eines zumindest mittelbar mit der Versorgungsbohrung (19) oder dem Hochdruckraum (15) in Wirkverbindung angeordneten Verformungsbereichs (27) zu erfassen, wobei die Messeinrichtung (30) ein Sensorelement (32) aufweist, das in Wirkverbindung mit der Oberfläche des Verformungsbereichs (27) verbunden ist, und wobei das Sensorelement (32) mittels einer das Sensorelement (32) zumindest teilweise überdeckenden Einrichtung in Richtung des Verformungsbereichs (27) mit einer Vorspannkraft (F) kraftbeaufschlagt ist,
**dadurch gekennzeichnet,**
**dass** das Sensorelement (32) unmittelbar an dem Verformungsbereich (27) aufliegt, und dass die Einrichtung ein zumindest bereichsweise flexibel ausgebildetes Sensorgehäuse (40) ist, welches das Sensorelement (32) mit Ausnahme der an dem Verformungsbereich (27) anliegenden Stirnseite des Sensorelements (32) umschließt.

2. Kraftstoffinjektor nach Anspruch 1,
**dadurch gekennzeichnet,**
**dass** das Sensorgehäuse (40) topf- bzw. deckeiförmig ausgebildet ist und eine Aufnahme (41) für das Sensorelement (32) aufweist, deren Tiefe (T) in nicht mit dem Injektorgehäuse (11) verbundenem Zustand geringer ist als die Höhe (t) des Sensorelements (32).

3. Kraftstoffinjektor nach Anspruch 1 oder 2,
**dadurch gekennzeichnet,**
**dass** das Sensorgehäuse (40) einen das Sensorelement (32) an dessen Umfang umgebenden Wandabschnitt (51) aufweist, und dass der Wandabschnitt (51) in Richtung der Kraftbeaufschlagung des Sensorelements (32) elastisch ausgebildet ist.

4. Kraftstoffinjektor nach einem der Ansprüche 1 bis 3,
**dadurch gekennzeichnet,**
**dass** das Sensorgehäuse (40) aus Metall besteht und mit dem Injektorgehäuse (11) mittels einer Schweißverbindung (43), vorzugsweise mittels einer Laserschweißnaht, verbunden ist.

5. Kraftstoffinjektor nach Anspruch 4,
**dadurch gekennzeichnet,**
**dass** das Sensorgehäuse (40) als Tiefziehteil ausgebildet ist.

6. Kraftstoffinjektor nach einem der Ansprüche 1 bis 5,
**dadurch gekennzeichnet,**
**dass** das Sensorelement (32) als Piezoelement (31) ausgebildet ist und auf seinen dem Sensorgehäuse (40) und dem Verformungsbereich (27) zugewandten Stirnseiten jeweils eine aus elektrisch nichtleitendem Material bestehende Isolationsschicht (46, 47) aufweist.

7. Kraftstoffinjektor nach einem der Ansprüche 1 bis 6,
**dadurch gekennzeichnet,**
**dass** das Sensorgehäuse (40) im Verbindungsbereich zum Verformungsbereich (27) einen radial umlaufenden Befestigungsbereich (42) aufweist.

8. Kraftstoffinjektor nach einem der Ansprüche 1 bis 7,
**dadurch gekennzeichnet,**
**dass** der Verformungsbereich (27) im Bereich einer sacklochförmigen Vertiefung (24) des Injektorgehäuses (11) angeordnet ist, und dass die Befestigung zwischen dem Sensorgehäuse (40) und dem Verformungsbereich (27) im Bereich des Grunds (26) der Vertiefung (24) ausgebildet ist.

9. Kraftstoffinjektor nach Anspruch 8,
**dadurch gekennzeichnet,**
**dass** der Verformungsbereich (27) im Bereich der Versorgungsbohrung (19) angeordnet ist und dass die Wanddicke des Injektorgehäuses (11) im Bereich der Vertiefung (24) gegenüber einem die Vertiefung (24) begrenzenden Bereich reduziert ist.
